# EUROPEAN PATENT APPLICATION

(11) **EP 1 450 165 A1**
(43) Date of publication of application: **25.08.2004**
(21) Application number: 04250840.8
(22) Date of filing: 17.02.2004
(51) Int. Cl.: G01R 13/02

(54) **Method of Automatically setting gain and offset based on region of interest**

(30) Priority: 18.02.2003 US 448380
(71) Applicant: Tektronix Inc., Beaverton, Oregon 97077 (US)
(72) Inventor: Ferguson, Kevin M, Beaverton, Oregon 97008 (US)
(74) Representative: Molyneaux, Martyn William

(57) **Abstract**

A method of automatically setting gain and offset for a signal is achieved by defining a region of interest within the signal, such as a portion of a video line, and acquiring the signal. Max and min values (14,16) for the region of interest are determined and tested against respective clipping levels (20). If either value clips, then the gain and offset are adjusted (22). Alternatively if only one value clips, then only the offset is adjusted, while if both values clip then the gain is adjusted until only one value clips. The adjustments of the gain and offset continue until a maximum number of attempts is reached (24) or neither max/min value is clipped. The resulting display of the signal shows the region of interest of the signal making optimum use of the display area.

## Description

### BACKGROUND OF THE INVENTION

The present invention relates to video measurements, and more particularly to a method of automatically setting gain and offset for a measurement instrument based on a region of interest.

In general purpose oscilloscopes gain and offset may be set automatically in order to make reasonable use of the dynamic range of an acquisition system and/or display such that, for example, there is no clipping. The gain is adjusted so that the maximum and minimum of a displayed signal fall within the vertical range of the display, and the offset is adjusted so that the displayed signal appears within the display area. Therefore gain and offset settings are important for manual and automatic signal measurements. Although as described above automatic gain and offset setting methods exist, they are not optimized for automatic measurements. For example when making a noise measurement on a video pedestal or other region of interest of a video signal, it currently is not possible to set the gain and offset such that only a portion of the signal is considered in the automatic gain/offset setting algorithm, allowing the rest of the signal to clip.

More recently digital oscilloscopes have provided simplified setup procedures based upon a desired measurement where waveform data is acquired using a group of default acquisition parameters including gain and offset. The different views of the waveform data are then displayed for selection by a user as a main display, with measured parameters being included in the main display. However automatic gain and offset is not adaptive between the various displays.

What is desired is a method of automatically setting the gain and offset of a general purpose oscilloscope based upon a region of interest in a waveform signal as opposed to the signal as a whole.

### BRIEF SUMMARY OF THE INVENTION

Accordingly the present invention provides a method of automatically setting gain and offset for a signal based on a region of interest within the signal. A region of interest within the signal is defined, such as a portion of a video line -- sync pulse, burst pulse, active video, etc. - according to a desired measurement and the signal is acquired. Max and min values for the region of interest are determined and tested against respective clipping levels. If either value clips, then the gain and offset are adjusted. Alternatively if only one value clips, then only the offset is adjusted, while if both values clip then the gain is adjusted. The adjustments of the gain and offset continue until a maximum number of attempts is reached or neither max/min value within the region of interest is clipped.

The objects, advantages and other novel features of the present invention are apparent from the following detailed description when read in conjunction with the appended claims and attached drawing.

### BRIEF DESCRIPTION OF THE SEVERAL VIEWS OF THE DRAWING

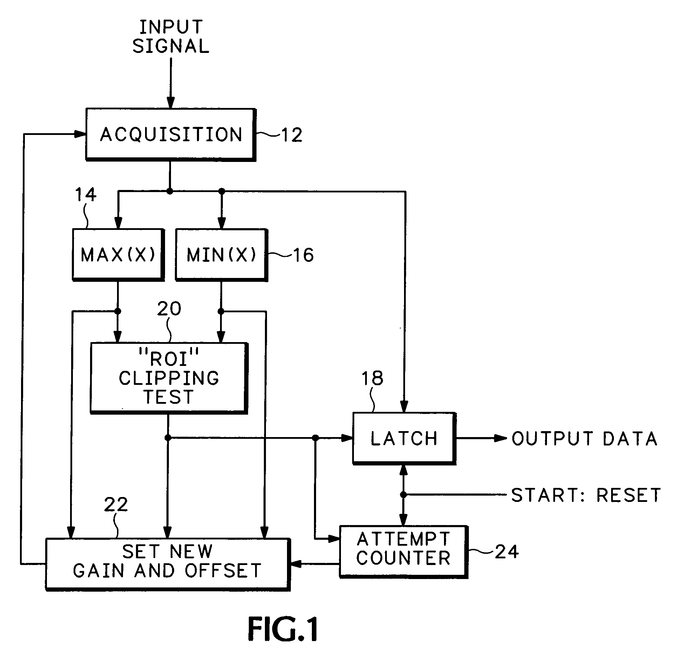

Fig. 1 is a block diagram logic view of a method of automatically setting gain and offset according to the present invention.

### DETAILED DESCRIPTION OF THE INVENTION

Referring now to Fig. 1 an input signal, such as a video signal or other electrical signal, is input to an acquisition module 12, as is well known in the art. The digitized signal captured by the acquisition module 12 is input to a maximum determination module 14, a minimum determination module 16 and an output latch **18**. The respective outputs from the max and min modules **14**, **16** are input to a region of interest (ROI) clipping test module **20** and to a gain/offset setting module **22**. The output from the ROI clipping test module **20** is also input to the gain/offset setting module **22** as well as to the output latch **18** and an "attempt" counter **24**. The attempt counter **24** provides an input to the gain/offset setting module **22**, while the output from the gain/offset setting module is provided to the acquisition module **12** to adjust the digitized signal accordingly. A Start/Reset signal is applied to the output latch **18** and the attempt counter **24** to initiate or reinitiate the gain/offset setting algorithm.

Using as an example a video signal or other signal having a repetitive feature, a portion of a video line may be used as the region of interest, such as the video pedestal portion, the horizontal sync tip portion, the color burst portion, etc., in the automatic gain/offset setting algorithm. By ignoring areas of the signal outside the ROI for the gain/offset determination, gain/offset may be optimized for automated and manual measurements and display of the signal. The following is one illustration of the automatic gain/offset setting method after qualifying the ROI, although other conventional methods may be used:
- Step 1:: Initialize: Attempts = 0
- Step 2:: Acquire data using current gain/offset values
- Step 3:: Get max and min within ROI
- Step 4:: Is there clipping within ROI or is Attempts>maxAttempts
No: done
Yes: continue
- Step 5:: Attempt = 0?
Yes: gain = min, offset = 0 (to be used in Step 2)
No: Calculate new gain, offset based on max and min (see below), increment Attempts

### Go to Step 2

The new gain for Step 5 "No" is given by:
Gain = constant/(max - min)
Offset = constant*(max + min)

An optional additional processing step may be added to fine tune the gain and offset values in the case where noise and quantization may create errors in the intermediate calculations. If only max or min cause clipping, but not both, after the first use of gain and offset values based on previous max and min values (first iteration), then the offset only is adjusted until either (i) both max and min clip again or (ii) neither clip. If both max and min clip again, then the gain is adjusted until only max or min cause clipping again, and the process repeats until neither max or min clip.

In another method:
If no clipping
   offset(n+1) = (max+min-AcquisitionDynamicRange)/2
   gain (n+1) = gain(n)*(desiredMax - desiredMin)/(measuredMax - measuredMin)
Else if clipping occurs only at max, but not at min
   offset(n+1) = offset(n) - (measuredMin - desiredMin)
   gain(n+1) = gain(n)
Else if clipping occurs only at min, but not max
   offset(n+1) = offset(n) - (measuredMax - desiredMax)
   gain(n+1) = gain(n)
Else
   gain(n+1) = minGain
      or depending on dynamic range of ROI of signal used
   gain(n+1) = gain(n)*attenFactor
where 0<attenFactor<1, specific values depending on the dynamic range of the signal versus the dynamic range of the input ROI. For example for a nominal input dynamic range of 700 mV video, a noise measurement ROI may have a dynamic range of 3 mV rms noise on a zero volt pedestal. Here the attenFactor may be 3/700 to reflect the ratio of these dynamic ranges.

The result on the display of the waveform signal is that the ROI is optimized for the display, i.e., makes optimum use of the display area, while portions of the waveform signal that are outside the ROI may be clipped.

Therefore the present invention provides better accuracy of measurement and display of what is measured by limiting the automatic gain/offset setting algorithm to a particular region of interest in a signal.

## Claims

1. A method of automatically setting gain and offset for the measurement and display of a signal comprising the steps of:
acquiring the signal;
defining a region of interest within the acquired signal;
determining max and min values for the acquired signal within the region of interest;
testing the max and min values for clipping on a display;
calculating from the max and min values a gain and offset for the signal when either the max or min value clips in the testing step; and
applying the gain and offset to the signal in the acquiring step.

2. The method as recited in claim 1 further comprising the step of reiterating the determining, testing; calculating and applying steps using the gain and offset from an immediately prior calculating step until a criterion is satisfied.

3. The method as recited in claim 2 wherein the criterion comprises neither max and min value clips in the testing step.

4. The method as recited in claim 2 wherein the criterion comprises a number of iterations equaling a specified maximum.

5. The method as recited in claim 2 wherein when only one of the max and min values clips in the testing step only offset is calculated in the calculating step in subsequent iterations until either both max and min values clip or neither clip.
